# EUROPÄISCHE PATENTSCHRIFT

(11) **EP 2 550 702 B1**
(45) Veröffentlichungstag und Bekanntmachung des Hinweises auf die Patenterteilung: **26.06.2019**
(21) Anmeldenummer: 11712792.8
(22) Anmeldetag: 11.03.2011
(51) Int. Cl.: H01M 10/48, H01M 10/42, G01R 31/36

(54) **ÜBERWACHUNGSSYSTEM FÜR EINE ENERGIESPEICHERZELLE**
CONTROL SYSTEM FOR AN ENERGY STORAGE CELL
SYSTÈME DE SURVEILLANCE POUR UN ACCUMULATEUR D'ÉNERGIE

(30) Priorität: 13.10.2010 DE 102010048379; 24.03.2010 US 316946 P
(43) Veröffentlichungstag der Anmeldung: 30.01.2013
(73) Patentinhaber: Samsung SDI Co., Ltd., Yongin-si, Gyeonggi-do (KR)
(72) Erfinder: GOLUBKOV, Andrej, A-8010 Graz (AT)
(74) Vertreter: Gulde & Partner
(86) Internationale Anmeldenummer: PCT/EP2011/053717
(87) Internationale Veröffentlichungsnummer: WO 2011/117089

(56) Entgegenhaltungen:
- EP-A2- 1 780 867
- WO-A1-2006/082425
- WO-A2-2009/036444
- DE-A1- 19 822 571
- US-A- 6 163 131

## Beschreibung

Die Erfindung betrifft ein Überwachungssystem zur Überwachung des Zustandes einer Energiespeicherzelle zur Speicherung elektrischer Energie, insbesondere einer galvanischen Energiespeicherzelle oder einer zumindest einen Kondensator aufweisenden Energiespeicherzelle.

Weiters betrifft die Erfindung ein Batteriesystem mit mehreren Energiespeicherzellen und einer zentralen Batteriesteuerung zur Steuerung und Überwachung der Energiespeicherzellen.

Herkömmliche Batteriesysteme werden üblicherweise in mehrere Module unterteilt. Jedes Modul weist seinerseits mehrere Zellen auf. Das Batteriesystem kann z. B. 6 Module zu je 10 Zellen aufweisen. Die Verwendung von in mehrere Module unterteilten Batteriesystemen ist beispielsweise bei Batterien für Antriebssysteme für Hybrid- oder Elektrofahrzeuge üblich, bei welchen ein hoher Energiebedarf besteht.

Jedes der herkömmlichen Module weist einen so genannten "Cell Supervision Circuit", im Folgenden "CSC" genannt, auf, dessen Aufgabe es ist, die Spannung der einzelnen Zellen des Moduls zu überwachen, Spannungsdifferenzen zwischen den Zellen des Gesamtsystems auszugleichen (Balancing) sowie andere sicherheitsrelevante Funktionen, wie beispielsweise eine Temperaturüberwachung, auszuführen.

Die CSCs der einzelnen Module kommunizieren üblicherweise über einen Datenbus mit einer Batteriesteuerung zur Steuerung und Überwachung der Energiezellen. Diese Batteriesteuerung wird als Batterie Managementeinheit, häufig als "Battery Management Unit" , bezeichnet. In den nachfolgenden Ausführungen wird die Batteriesteuerung bzw. Battery Management Unit verkürzt als BMU bezeichnet. Auf der BMU läuft die Steuersoftware des Batteriesystems. Die BMU hat herkömmlicher Weise vielfältige Aufgaben. Die für die gegenständliche Erfindung wichtigsten sind:
a) die BMU entscheidet, welche Zellen gebalanced werden und wie lange gebalanced wird, also welche Zellen entladen (passives Balancing) oder gegebenenfalls geladen werden (aktives Balancing).
b) Auf Basis der Daten, die von den CSCs zur BMU geschickt werden, wird von der Steuersoftware entschieden, ob sich das System in einem sicheren Zustand befindet, oder ob reagiert werden muss. Zu diesen Daten gehören beispielsweise die Temperaturen der Module und alle Zellspannungen.

CSCs, wie sie derzeit verwendet werden, haben jedoch, wie im Folgenden näher erläutert, eine Reihe von Nachteilen.

Das Batteriesystem besteht aus vielen Zellen. So kann die Zellanzahl durchaus 400 oder mehr betragen, wobei jede einzelne Zellspannung überwacht werden muss. Bei einer Parallelschaltung von X-Zellen muss zwar nur jede X-te Zelle überwacht werden, allerdings wird hierfür ein Spannungsabgriffskabel benötigt. Sollte jedoch auch nur einer der dünn ausgeführten Spannungsabgriffsleiter brechen, so darf das System nicht betrieben werden.

Die Spannung zwischen den Pins im Stecker, dort wo die Spannungsabgriffe am CSC zusammengeführt werden, kann beispielsweise bei 12 Zellen pro Modul 50V betragen. Durch Kondenswasser und Verschmutzung kann es dort am CSC zu Kriechströmen und Korrosion kommen.

Eine schwer beherrschbare Fehlerquelle herkömmlicher Systeme sind Kurzschlüsse in den Spannungsabgriffen und am CSC. Die vielen Spannungsabgriffe können schwer mit konventionellen Sicherungen geschützt werden. Kurzschlüsse können entstehen (a) durch mechanisches Abscheuern oder Bruch, b) durch Fremdkörper, c) durch Unachtsamkeit in der Montage oder in der Wartung und d) als Folgefehler bei Austritt von Kühlflüssigkeit. So kann beispielsweise leitendes Material durch Elektrolyse der Kühlflüssigkeit an benachbarten spannungsführenden Leitern abgeschieden werden und eine Brücke für den Kurzschluss herstellen.

Durch die vielen gegen Masse spannungsführenden Teile erhöht sich auch die Wahrscheinlichkeit für einen Masseschluss und die Gefahr eines Stromschlags für Personen beim Arbeiten am Batteriesystem.

Auch müssen die CSCs für neue Batteriesysteme teilweise angepasst und neu entwickelt werden.

Weiters können bei Li-Ionen Batterien Lithiumabscheidungen (Lithiumdendriten) auf einer überlasteten Anode schwer erkannt werden. Die Lithiumdendriten können im schlimmsten Fall zu einer Beschädigung einer Separatorfolie und in weiterer Folge zu einem internen Kurzschluss in der Zelle führen.

Die WO 2006/082425 A1 offenbart ein Batteriemanagementsystem zur Verwendung mit einer oder mehreren Zellen, umfassend das System mit einem oder mehreren Batteriemonitoren und einer programmierbaren Logik, die mit dem einen oder den mehreren Batteriemonitoren verbunden ist, um ihren Batteriebetrieb zu modifizieren und den Batteriestatus zu melden. Die programmierbare Logik kann konfiguriert sein, um physikalische Daten bezüglich der Auswirkung der Temperatur auf die Batteriekapazität und / oder den Einfluss der Temperatur auf die Batterie-Selbstentladung zu analysieren. Die Implementierung ist auf alle elektrischen Energiespeichersysteme anwendbar, die seriell oder parallel geschaltete elektrochemische Speicher umfassen.

Mit der WO 2009/036444 A2 wurde ein Batteriemanagementsystem bekannt, welches eine oder mehrere Lithiumionenzellen in elektrischer Verbindung umfasst, wobei jede Zelle erste und zweite Arbeitslektroden und eine oder mehrere Referenzelektroden aufweist, wobei jede Referenzelektrode von den Arbeitselektroden elektronisch isoliert ist. Weiterhin wird ein Batteriemanagementsystem mit einer Batteriezustandsüberwachung beschrieben, wobei der Monitor zum Empfangen von Informationen bezüglich der Potentialdifferenz der Arbeitselektroden und dem Potential einer oder mehrerer Arbeitselektroden gegenüber der Referenzelektroden eingerichtet ist. Aus der US 6 163 131 A sind Batterien mit eingebautem Steuergerät bekannt, bei denen jede individuelle elektrochemische Zelle ihr eigenes eingebautes Steuergerät aufweist.

Die DE 198 22 571 A1 beschreibt eine Anordnung zum Überwachen der Betriebsdaten von elektrischen Batterien, wobei ein elektronischer Chip in das Batteriegehäuse integriert ist. Zur Datenübertragung werden Lichtleiter eingesetzt.

Die US 6 163 131 A offenbart ein Überwachungssystem zur Überwachung des Zustandes einer Energiespeicherzelle zur Speicherung elektrischer Energie, insbesondere einer galvanischen Energiespeicherzelle oder einer zumindest einen Kondensator aufweisenden Energiespeicherzelle, wobei innerhalb der Energiespeicherzelle eine integrierte Elektronik zur Zustandsüberwachung der Energiespeicherzelle angeordnet ist, so dass durch Erfassen chemischer Zersetzungsprodukte eine Bestimmung des chemischen Zustands der Energiespeicherzelle vorgenommen werden kann, wobei die integrierte Elektronik eine Sende/Empfangseinheit zum Datenaustausch mit einer außerhalb der Energiespeicherzelle angeordneten Batteriesteuerung aufweist.

Es ist daher eine Aufgabe der Erfindung, die Sicherheit des Batteriesystems bei gleichzeitiger Minimierung von Material und Montagekosten zu erhöhen, ohne die Überwachungsfunktionen zu beeinträchtigen.

Diese Aufgabe wird mit einem Überwachungssystem mit den Merkmalen des Anspruchs 1 gelöst.

Mit der erfindungsgemäßen Lösung lässt sich einerseits verbesserter Personenschutz realisieren, andererseits kann optional auch eine genauere Bestimmung des chemischen Zustands der einzelnen Zellen vorgenommen werden. Durch eine drahtlose Kommunikation zwischen der integrierten Elektronik und der Batteriesteuerung lässt sich eine Datenübertragung auf besonders sichere und einfache Weise realisieren.

Alternativ zur Verwendung einer drahtlosen Datenübertragung zwischen integrierter Elektronik und Batteriesteuerung kann, nicht erfindungsgemäß, eine Datenübertragungsstrecke zwischen der integrierte Elektronik und der Batteriesteuerung von einem elektrischen Datenbus oder von einer Hauptstromleitung, auf welche ein Signal aufmodulierbar ist, gebildet sein.

Eine weitere nicht erfindungsgemäße Ausführungsform der Erfindung, welche sich durch eine geringe elektromagnetische Störanfälligkeit auszeichnet, sieht vor, dass die integrierte Elektronik über eine optische Übertragungsstrecke, insbesondere über eine Infrarotübertragungsstrecke mit und ohne elektrisch isolierendes Glasfaserkabel, mit der Batteriesteuerung verbunden ist.

Gemäß der Erfindung, welche sich durch eine besonders zuverlässige Erfassung des Zustandes der Energiezelle auszeichnet, ist es vorgesehen , dass die integrierte Elektronik Sensoren aufweist, um die Temperatur und/oder den Ladezustand und/oder chemische Zersetzungsprodukte der Energiespeicherzelle zu erfassen.

Ein passives Balancing der Energiespeicherzelle lässt sich auf einfache Weise dadurch realisieren, dass die integrierte Elektronik einen zuschaltbaren Entladewiderstand aufweist.

Eine besonders genaue und zuverlässige Erfassung des Ladezustands der Energiespeicherzelle wird dadurch erreicht, dass die integrierte Elektronik eine Referenzelektrode zur getrennten Messung eines Anoden und Kathodenpotentials der Energiespeicherzelle umfasst.

Eine Identifikation einer Energiespeicherzelle und somit die eindeutige Zuordnung einer Fehlfunktion oder eines korrekten Betriebszustandes zu dieser Energiespeicherzelle lässt sich dadurch erzielen, dass die integrierte Elektronik einen Identifikationscode aufweist, der in einem Speicher der integrierten Elektronik abgelegt ist. Bei diesem Identifikationscode kann es sich um einen alphanumerischen Code, beispielsweise um eine Seriennummer eines Chips der integrierten Elektronik oder der Energiespeicherzelle handeln.

Die Erfindung, welche sich durch einen geringen Platzbedarf und gute Verarbeitungseigenschaften bei der Herstellung der Energiespeicherzelle auszeichnet, sieht vor, dass die integrierte Elektronik auf einer Trägerfolie angeordnet ist. In diesem Zusammenhang ist es von besonderem Vorteil, wenn es sich bei der Energiespeicherzelle um eine in Folientechnologie hergestellte Zelle handelt.

Eine besonders vorteilhafte Weiterbildung der Erfindung, welche eine Analyse der Verwendung der Energiespeicherzelle ermöglicht, sieht vor, dass die integrierte Elektronik dazu eingerichtet ist, Daten zur Zellbenützung zu speichern.

Die oben genannte Aufgabe lässt sich auch mit einem Batteriesystem der eingangs genannten Art erfindungsgemäß dadurch lösen, dass das Batteriesystem ein erfindungsgemäßes Überwachungssystem aufweist.

Die Erfindung samt weiteren Vorteilen wird im Folgenden anhand einiger nicht einschränkender Ausführungsbeispiele näher erläutert, welche in den Zeichnungen dargestellt sind. In diesen zeigen schematisch:
Fig. 1 eine Energiespeicherzelle mit einer erste Variante eines erfindungsgemäßen Überwachungssystems für eine Energiespeicherzelle und
Fig. 2 eine Energiespeicherzelle mit einer zweiten Variante eines erfindungsgemäßen Überwachungssystems.

Einführend sei festgehalten, dass die vorliegende Erfindung nicht auf die Anwendung in galvanischen Energiespeicherzellen (z.B. Lithium-Ionen Zellen) beschränkt ist, sondern auch bei anderen Arten von Energiespeichern bzw. Energiespeicherzellen, wie beispielsweise Kondensatoren, insbesondere Doppelschicht-Kondensatoren, zum Einsatz kommen kann.

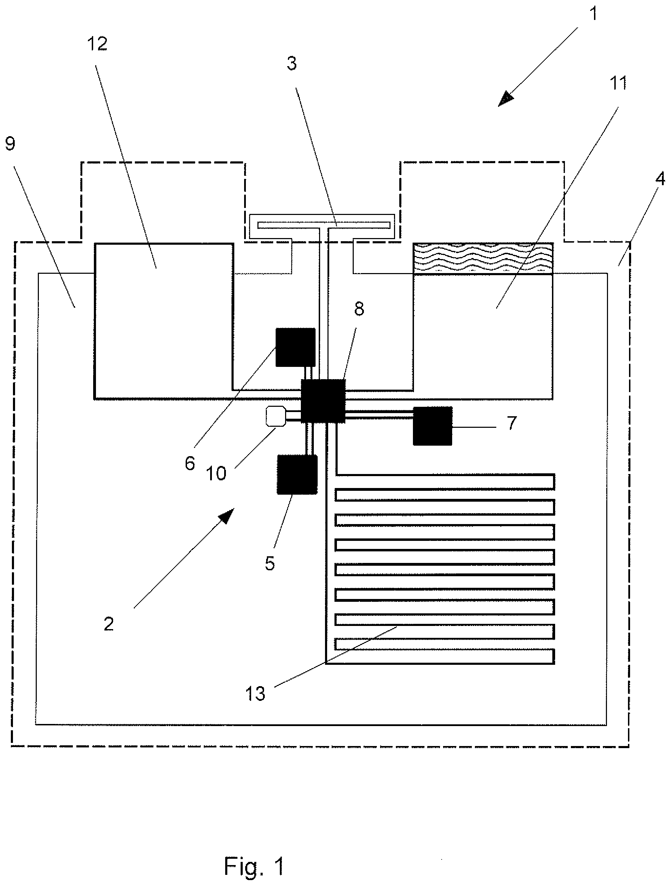

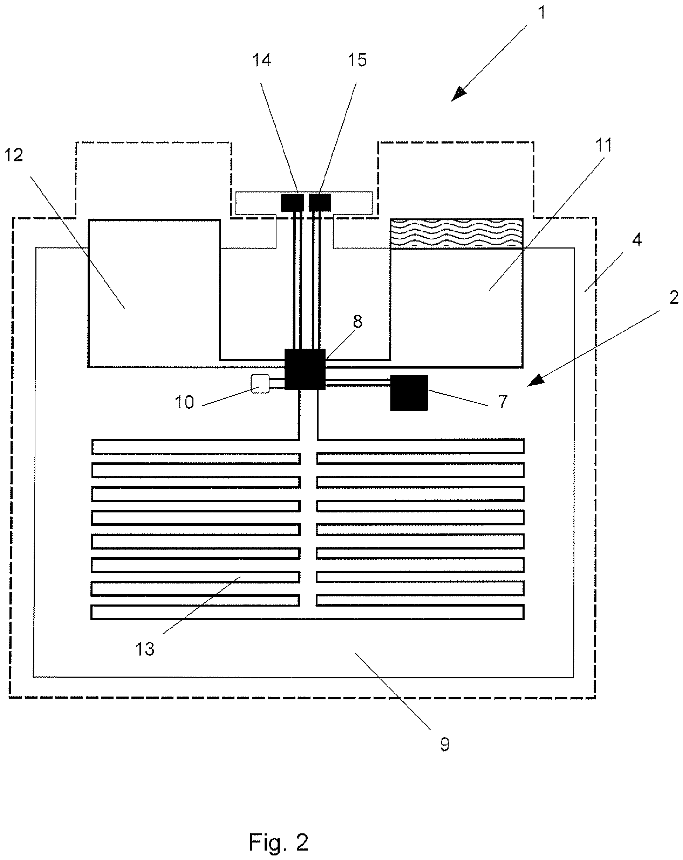

Wie Fig. 1 zu entnehmen ist, werden bei einer erfindungsgemäßen Energiespeicherzelle 1 die im Stand der Technik üblicherweise verwendeten CSCs durch eine direkt in die Energiespeicherzelle 1 integrierte Elektronik 2 ersetzt, welche im Folgenden als Intergrated Cell Curcuit oder kurz ICC bezeichnet wird. Mehrere erfindungsgemäße Energiespeicherzellen 1, wie sie in Fig. 1 oder 2 dargestellt sind, können zu einem Batteriesystem zusammengefasst werden. Jede Energiespeicherzelle 1 kann über ihren eingebauten ICC 2 erfindungsgemäß drahtlos mit einer hier nicht näher dargestellten BMU des Batteriesystems kommunizieren. Hierzu kann der ICC 2 eine Sende/Empfangseinheit 3 zum drahtlosen Datenaustausch mit der außerhalb der Energiespeicherzelle 1 angeordneten BMU aufweisen oder mit einer entsprechenden Sende/Empfangseinheit 3 verbunden sein. Der ICC 2 ist bevorzugterweise für eine bidirektionale Kommunikation mit der BMU eingerichtet.

Als Kommunikationstechnologie zur Datenübertragung zwischen ICC 2 und BMU kann beispielsweise die auf Funk basierende Kommunikationstechnologie der RFID zum Einsatz kommen. Alternativ wäre, nicht erfindungsgemäß, eine Kommunikation zwischen dem ICC 2 und der BMU über ein aufmoduliertes Signal auf Hauptsstromkabeln oder über einen elektrischen Datenbus möglich. Auch könnte zwischen dem ICC 2 und der BMU eine optische Datenübertragungsstrecke vorgesehen sein.

Die Maximalspannung in einer herkömmlichen, als Energiespeicherzelle 1 verwendeten Li-Ionen Zelle beträgt üblicherweise 4,2V. Da sich der ICC 2 innerhalb der Energiespeicherzelle 1 befindet sieht dieser bei Verwendung einer Li-Ionen Zelle als Energiespeicherzelle 1 nie eine größere Spannung als 4,2V. Die zu beherrschende Spannung ist somit viel kleiner als die 50V, die an einem konventionellen CSC anliegen.

Unter Stromlast fällt an Übergangswiderständen der Energiespeicherzelle 1 Spannung ab. Da der ICC 2 die Spannung direkt in der Energiespeicherzelle 1 misst, kann auch der durch den Spannungsabfall an den Übergangswiderständen verursachte Fehler minimiert werden. Durch den Einbau des ICC 2 in ein luftdicht abgeschlossenes Zellgehäuse 4 der Energiespeicherzelle 1 können auch die Möglichkeiten für einen internen Kurzschluss (Zwischen zwei Zellen, oder zwischen Zelle und Masse) stark minimiert werden.

Der Montage und Wartungsaufwand bei der erfindungsgemäßen Lösung verringert sich gegenüber den herkömmlichen Lösungen wesentlich, da CSC und Spannungsabgriffskabel wegfallen. Weiters können die erfindungsgemäßen Energiespeicherzellen 1 leichter ausgetauscht werden.

Weiters weist der ICC 2 Sensoren 5, 6, 7 auf bzw. ist mit in der Energiespeicherzelle 1 angeordneten Sensoren 5, 6, 7 verbunden, um die Temperatur und den Ladezustand und/oder chemische Zersetzungsprodukte und/oder den Druck der Energiespeicherzelle 1 zu erfassen. Durch Verwendung eines chemischen Sensors 5 lässt sich der Zustand der Energiespeicherzelle 1 noch genauer erfassen. So können chemische Zersetzungsprodukte gemessen werden, die auf ein baldiges Versagen der Energiespeicherzelle 1 hinweisen. Durch den chemischen Sensor 5, der auf Zersetzungsprodukte der Batteriekomponenten der Energiespeicherzelle 1 reagieren kann, ist auch eine Alterungs- und Restkapazitätsbestimmung ermöglicht. Weiters kann vor einem baldigen Komplettversagen der Energiespeicherzelle 1 gewarnt werden. Dadurch besteht auch die Möglichkeit, auch unter mehreren parallel geschalteten Energiespeicherzellen 1 die fehlerhafte Zelle zu erkennen. Das wäre mit einer reinen Spannungsmessung nicht möglich, da die parallel geschalteten Energiespeicherzellen 1 zwangsläufig auch die gleiche Spannung aufweisen.

Mit dem Drucksensor 6 lässt sich beispielsweise der Gasdruck in einer Metal-Can Zelle bestimmen. Mit dem ermittelten Gasdruck kann dann auf die Alterung der Zelle zurück gerechnet werden.

Als Temperatursensor 7 kämen ein in einem ICC Chip 8 integrierter Sensor oder auch eine eigene Komponente auf einer ICC Trägerfolie 9 in Frage. Der Temperatursensor 7 sollte bevorzugterweise eine Temperatur im Bereich von -30 bis + 70 °C mit einer Genauigkeit unter 2°C messen können. Aus Kostengründen könnte auch nur ein gewisser Prozentsatz an Energiespeicherzellen 1 eines erfindungsgemäßen Batteriesystems mit einem Temperatursensor 7 ausgestattet werden. Falls eine kostengünstige Thin-Film Technologie zur Herstellung der Temperatursensoren 7 verwendet wird, könnte aber auch eine Matrix aus Temperatursensoren 7 über die ganze Fläche der Trägerfolie 9 des ICC 2 verteilt werden. Damit ließen sich Hot-Spots im Betrieb der Energiespeicherzelle 1 frühzeitig erkennen.

Darüber hinaus werden durch den Einbau einer Referenzelektrode 10 in den ICC 2 die Potentiale der Anode und der Kathode getrennt gemessen. Damit lässt sich der Ladezustand der Energiespeicherzelle 1 besser bestimmen. Die Verwendung der zusätzlichen Referenzelektrode 10 kann auch entscheidende Vorteile bei der Bestimmung des chemischen Zustandes der Energiespeicherzelle 1 erbringen. Die Referenzelektrode 10 kann beispielsweise aus reinem Lithium oder aus Platin ausgeführt sein und sollte an den elektrochemischen Reaktionen der Energiespeicherzelle 1 nicht teilnehmen. Durch eine geringe Größe der Referenzelektrode 10 können auch Sicherheitsprobleme vermieden werden. Durch die getrennte Messung von Anoden- und Kathodenpotential lassen sich auch Zusatzinformationen zur Bestimmung des Ladezustands und zu Alterungseffekten der Energiespeicherzelle 1 gewinnen. Weiters können Zusatzinformationen zum State of Health, kurz SOH, der Energiespeicherzelle erfasst und an die BMU übermittelt werden.

Insbesondere können bei bekanntem Anodenpotential sicherheitskritische Lithiumabscheidungen erkannt werden.

Wie in Fig. 1 dargestellt und bereits oben teilweise erwähnt, weist der ICC 2 einen ICC Chip 8, eine Trägerfolie 9, eine Referenzelektrode 10, Spannungsabgriffe 11, 12, einen chemischen Sensor 5, einen Drucksensor 6, einen Temperatursensor 7, einen Folienwiderstand 13 und eine in diesem Fall als Antenne ausgeführte Sende/Empfangseinheit 3 auf.

Der Folienwiderstand 13 kann für das passive Balancing der Energiespeicherzelle 1 verwendet werden. Über einen Transistor kann der Folienwiderstand 13 parallel zu den Zellelektroden geschaltet. Somit ist ein kontrolliertes Balancing möglich. Bei genügend Leistung wäre auch ein Heizen der Energiespeicherzelle 1 möglich, damit könnte die Energiespeicherzelle 1 leichter im idealen Betriebsbereich gehalten werden. Der Transistor könnte beispielsweise in MOSFET Technik ausgeführt sein. Diese Art von Folienwiderständen gibt es auf dem Markt bereits und ist dem Fachmann bekannt.

Der ICC 2 kann in der Technologie ,Flexible Electronics' auf der Trägerfolie 9 realisiert werden. So werden beispielsweise RFID-Tags schon lange in dieser Technologie gefertigt. Der ICC Chip 8 selbst kann somit in der gleichen Technologie wie herkömmliche RFID Chips hergestellt werden. RFID Chips gibt es miniaturisiert bis zu einer Größe von 50µm x 50µm (Hitachi). Der ICC Chip 8 kann beispielsweise folgende Funktionen ausführen: (a) Funkkommunikation mit der BMU (b) genaue Analog/ Digitalwandlung der Zellspannung (c) Messung der Temperatur (intern oder über Zusatzkomponente) (d) Zuschaltung des Folienwiderstands 13 für das Balancing (f) Auslesen der optionalen Sensoren 5, 6, 7. Der ICC Chip 8 arbeitet bevorzugterweise energiesparend und erhöht so die Selbstentladung der Energiespeicherzelle 1 nur wenig. Idealerweise kann ein aktivierbarer Stromsparmodus bei nicht betriebenem System vorgesehen sein.

Die Trägerfolie 9 ist bevorzugterweise von geringer Dicke, damit das Volumen der Energiespeicherzelle 1 nicht wesentlich vergrößert wird. Die ICC Trägerfolie 9 kann zusammen mit den Anoden-, Kathoden- und Separatorfolien gestackt zu der Energiespeicherzelle 1 aufgebaut werden. Allgemein kann der ICC 2 ähnlich wie die üblichen Kathoden- und Anodenfolien integriebar sein, damit bei der Zellassemblierung keine zusätzlichen neuartigen Prozesse anfallen. Zum Zusammenbau der Energiespeicherzelle 1 können Anoden-, Kathoden- und Separatorfolien wie bisher aufeinandergestapelt werden. Zusätzlich wird die ICC Trägerfolie 9 mit dazugelegt. Kathoden- und anodenseitige ,Current Collectors' können verschweißt werden. Die Zellspannungsabgriffe der ICCs 2 können im selben Arbeitsschritt mitgeschweißt werden. Laminierte Außenfolien können angelegt und an den Siegelrändern (Kunststoff-)verschweißt werden. Die Antennenlasche/LED-lasche soll dabei nach außen durch die Siegelnaht herausragen. Die Antennenlasche/LED-Lasche kann dann umgeknickt und außen auf die Zellaußenfläche angeklebt werden. Die weiteren Schritte der Fertigung können wie bei den bereits aus dem Stand der Technik bekannten Energiespeicherzellen erfolgen.

Günstigerweise weist die ICC Trägerfolie 9 überall eine konstante Dicke auf. Verdickungen in der ICC Trägerfolie 9 könnten sonst in die Kathoden- und Anodenfolien hineingedrückt werden und diese beschädigen. Der Druck entsteht bei Pouch-Zellen durch die äußere mechanische Zellbefestigung im Batteriesystem oder bei Metal-Can Zellen durch das starre Zellgehäuse und alterungs- und zyklusbedingte Ausdehnung des Anoden- und Kathodenmaterials im inneren der Zelle. Die Erfindung ist bei jeder der genannten Zellentypen anwendbar aber nicht auf diese beschränkt, so könnte die erfindungsinhaltliche Überwachungselektronik beispielsweise auch in einem zylindrischen Energiespeicher-/Zelle zur Anwendung kommen. Zum Schutz vor dem Elektrolyt kann der ICC 2 von beiden Seiten mit Kunststofffolien versiegelt sein.

Auch kann aufgrund der erfindungsgemäßen Lösung ein Zellpackaging flexibler gestaltet werden. So können auf einfachere Weise als bisher möglich Batteriesysteme mit unterschiedlicher Anzahl an Energiespeicherzellen 1 realisiert werden, die Anzahl der Energiespeicherzellen 1 im Batteriesystem muss kein Vielfaches der Zellen pro Modul sein. Auch halb mit Zellen aufgefüllte Spezialmodule werden nicht benötigt.

Im ICC Chip 8 können Logdaten zur Benützung der Energiespeicherzelle 1 gespeichert und bei Recyceln oder bei einem Service analysiert werden.

Die Spannungsabgriffe 11 und 12 werden einerseits für die Stromversorgung des ICC 2 gebraucht, andererseits kann so die Zellspannung der Energiespeicherzelle 1 gemessen werden. Die Genauigkeit der Spannungsmessung sollte relativ hoch sein, idealerweise besser als 10mV mit einem Spannungsbereich von 0V bis 4.5V. Die Spannungsabgriffe des ICC 2 sind günstigerweise (mechanisch) kompatibel zu den in der Zelle verwendeten ,Current Collector' Folien, je nach dem in der Zelle verwendetem Material, beispielsweise aus Aluminium und Kupfer aufgebaut. Man könnte die Spannungsabgriffe 11 und 12 dann im gleichen Prozessschritt, in dem die , Current Colectors' verschweißt werden, einfach mitschweißen. Während beispielsweise die anodenseitigen , Current Collectors' als Kupferfolien ausgeführt werden, sind es auf den Kathodenseite beispielsweise Aluminiumfolien. ,Flexible Electronics' Schaltkreise werden üblicherweise mit Kupferleiterbahnen ausgeführt. Die Schweißung auf der Anodenseite ist also leicht realisierbar. Auf der Kathodenseite kann entweder der ganze Spannungsabgriff 11 aus Aluminium gefertigt sein oder es könnte ein Materialübergang Kupfer-Aluminium hergestellt werden - entweder direkt auf der Schweißlasche, wenn es der Schweißprozess erlaubt, oder vorher zwischen dem ICC Chip 8 und der Anoden- Schweißstelle.

Die Kommunikation der einzelnen ICCs 2 mit der BMU kann wie bereits oben erwähnt, mit verschiedenen Technologien realisiert werden:
1. Kommunikation über elektromagnetischen Funk, angelehnt an die RFID Technologie
2. Optische Datenübertragung mit Verwendung von Infrarottransceivern, ohne Lichtleiterkabel
3. Optische Datenübertragung mit Verwendung von Infrarottransceivern, mit Lichtleiterkabel (nicht erfindungsgemäß)
4. Kommunikation über ein auf die Hauptstromleitungen aufmoduliertes Signal (nicht erfindungsgemäß)
5. Kommunikation mit einem konventionellen elektrischen Datenbus (nicht erfindungsgemäß) Je nach verwendeter Kommunikationstechnologie werden andere Systemkomponenten für die Kommunikation benötigt.

Für den Fall einer Funkkommunikation zwischen ICC 2 und BMU ist eine ICC Antenne vorgesehen. Da das Funksignal Metall nicht durchdringen kann, sollte die Funkstrecke von der ICC Antenne zur BMU Antenne metallfrei sein. Die Funkstrecke muss jedoch keine Gerade sein, da die Radiowellen an Metallwänden reflektiert werden können. So besitzen beispielsweise Li-Ionen Zellen üblicherweise ein Metallgehäuse. Bei Pouch Zellen kann eine Aluminiumschicht als Diffusionsbarriere für die Elektrolytflüssigkeit in die äußerste Folie eingeschweißt sein, bei den Metal-Can Zellen besteht das Gehäuse üblicherweise ganz aus Metall. Um eine Funkverbindung zu ermöglichen, kann bei Pouch Zellen die ICC Folie eine zusätzliche Lasche mit Antennenleiterbahnen aufweisen. Beim Anlegen der äußeren Folien während der Zellfertigung lässt man die Antennenlasche nach außen durch die Siegelnaht herausragen. Die Antenne ist nun außerhalb des Zellgehäuses. Die Lasche kann zum Schluss umgeknickt und an der Zellaußenwand angeklebt (z.B. auf die Siegelnaht) werden. Der Platz an dem die Antennenlasche herausgeführt wird, kann so gewählt werden, dass im Batteriesystem eine günstige Funkverbindung zur BMU möglich ist.

Bei Metal-Can Zellen ist die Situation schwieriger als bei Pouch-Zellen. Eine Lösung stellt beispielsweise ein für die Radiofrequenz durchsichtiges Plastik- bzw. Kunststofffenster an einer geeigneten Stelle des Metallgehäuses dar. Das Fenster kann so ausgeführt werden, dass es gleichzeitig als Überdruckventil dient.

Optional zur Funktechnologien können aber auch andere bidirektionale, nicht erfindungsgemäße, Kommunikationstechniken zum Einsatz kommen. So könnte die Informationsübertragung durch Aufmodulieren des Kommunikationsträgersignals auf die Hochstromanschlüsse erfolgen.

Auch könnte, wie in Fig. 2 dargestellt, statt einer Antenne eine LED 14 und ein Lichtsensor 15 mit einer Lasche nach außen geführt sein. Über das Batteriegehäuse können entsprechende Gegenstellen verteilt werden. Die Kommunikation zwischen Energiespeicherzelle 1 und der BMU würde in diesem Fall optisch erfolgen. Diese Variante zeichnet sich unter anderem durch eine gute elektromagnetische Verträglichkeit aus. Es wäre aber auch möglich, jede Energiespeicherzelle 1 über ein Lichteiterkabel an die BMU anzuschließen (nicht erfindungsgemäß), Damit würden vor allem Verschmutzungsprobleme entfallen. Alternativ könnte die Datenübertragung zwischen ICC 2 und BMU mit einem konventionellen seriellen elektrischen Datenbus erfolgen (nicht erfindungsgemäß). Jeder ICC 2 der Energiespeicherzellen 1 des Batteriesystems könnte in diesem Fall elektrisch an den Datenbus angebunden werden. Weitere Durchführungen durch das Zellgehäuse würden benötigt. Der Transceiver des ICCs ist in diesem Fall günstigerweise gut von den anderen Komponenten der Energiespeicherzelle 1 isoliert, damit an den Datenbus keine Hochspannungspotentiale angelegt werden.

Jeder ICC Chip 8 kann gemäß einer vorteilhaften Variante der Erfindung einen einzigartigen ID-Code, im Folgenden kurz ID genannt, besitzen, damit jeder ICC eindeutig identifizierbar ist. Die Verwendung einer ID ermöglicht auch die Realisierung eines Kommunikationsprotokolls zwischen den einzelnen ICCs und der BMU. Gemäß einem einfachen Kommunikationsprotokolls kann sich beim Einschalten des Batteriesystems jede Energiespeicherzelle 1 mit ihrer ID bei der BMU anmelden. Bevorzugterweise kommt ein Antikollisionsverfahren zum Einsatz, damit nicht zwei ICCs 2 gleichzeitig senden. Sobald sich bei der BMU eine Anzahl an Energiespeicherzellen 1 angemeldet hat, die der Anzahl der Energiespeicherzellen 1 im Batteriesystem entspricht, kann die Betriebskommunikation freigegeben werden.

In der Betriebskommunikation kann die BMU die IDs der Zellen der Reihe nach durchgehen und nach der letzten ID wieder bei der ersten ID anfangen. Bei jeder ID wird dabei eine Anfrage der BMU ausgeschickt, und der ICC 2 mit der richtigen ID meldet den Zustand seiner Energiespeicherzelle an die BMU. In der Anfrage der BMU kann auch eine Anweisung für das Balancing der entsprechenden Energiespeicherzelle 1 enthalten sein.

Sollte eine der ICCs 2 nicht antworten, so kann die Anfrage der BMU wiederholt werden. Sollten auch nach weiteren Versuchen der Kommunikationsaufnahme keine Antwort erfolgen, dann könnte das Batteriesystem aus Sicherheitsgründen abgeschaltet werden.

**Bezugszeichenliste**

| | |
|---|---|
| Energiespeicherzelle | 1 |
| Integrierte Elektronik | 2 |
| Sende/Empfangseinheit | 3 |
| Zellgehäuse | 4 |
| Chemischer Sensor | 5 |
| Drucksensor | 6 |
| Temperatursensor | 7 |
| ICC Chip | 8 |
| Trägerfolie | 9 |
| Referenzelektrode | 10 |
| Spannungsabgriff Kathode | 11 |
| Spannungsabgriff Anode | 12 |
| Folienwiderstand | 13 |
| LED | 14 |
| Lichtsensor | 15 |

## Patentansprüche

1. Überwachungssystem zur Überwachung des Zustandes einer Energiespeicherzelle
(1) zur Speicherung elektrischer Energie, insbesondere einer galvanischen Energiespeicherzelle (1) oder einer zumindest einen Kondensator aufweisenden Energiespeicherzelle (1), wobei innerhalb der Energiespeicherzelle (1)eine auf einer Trägerfolie (9) direkt in die Energiespeicherzelle (1) integrierte Elektronik
(2) zur Zustandsüberwachung der Energiespeicherzelle (1) angeordnet ist, wobei die integrierte Elektronik (2) auf der Trägerfolie (9) einen ICC Chip (8), Sensoren (5,6,7) zur Erfassung der Temperatur und des Ladezustandes und des Druckes aufweist, **gekennzeichnet dadurch, dass** sie außerdem eine Sende/Empfangseinheit (3) zum drahtlosen Datenaustausch mit einer außerhalb der Energiespeicherzelle (1) angeordneten Batteriesteuerung, sowie eine Referenzelektrode (10) zur getrennten Messung eines Anoden und Kathodenpotentials der Energiespeicherzelle (1) aufweist.

2. Überwachungssystem nach Anspruch 1, **dadurch gekennzeichnet, dass** die integrierte Elektronik (2) über eine optische Übertragungsstrecke, insbesondere über eine Infrarotübertragungsstrecke mit und ohne elektrisch isolierendes Glasfaserkabel, mit der Batteriesteuerung verbunden ist.

3. Überwachungssystem nach einem der Ansprüche 1 bis 2, **dadurch gekennzeichnet, dass** die integrierte Elektronik (2) Sensoren (5, 6, 7) aufweist oder mit in der Energiespeicherzelle (1) angeordneten Sensoren (5, 6, 7) verbunden ist, um die Temperatur und/oder den Ladezustand zu erfassen.

4. Überwachungssystem nach einem der Ansprüche 1 bis 3, **dadurch gekennzeichnet, dass** die integrierte Elektronik (2) einen zuschaltbaren Entladewiderstand (13) aufweist.

5. Überwachungssystem nach einem der Ansprüche 1 bis 4 **dadurch gekennzeichnet, dass** die integrierte Elektronik (2) einen Identifikationscode aufweist, der in einem Speicher der integrierten Elektronik (2) abgelegt ist.

6. Überwachungssystem nach einem der Ansprüche 1 bis 5, **dadurch gekennzeichnet, dass** die integrierte Elektronik (2) dazu eingerichtet ist, Daten zur Zellbenützung zu speichern.

7. Batteriesystem mit mehreren Energiespeicherzellen (1) und einer zentralen Batteriesteuerung zur Steuerung und Überwachung der Energiespeicherzellen (1), **dadurch gekennzeichnet, dass** das Batteriesystem ein Überwachungssystem nach einem der Ansprüche 1 bis 6 aufweist.

## Claims

1. Monitoring system for monitoring the state of an energy storage cell (1) for storing electrical energy, in particular a galvanic energy storage cell (1) or an energy storage cell (1) having at least one capacitor, wherein electronics (2) for monitoring the state of the energy storage cell (1) are arranged within the energy storage cell (1) in a manner integrated directly in the energy storage cell (1) on a carrier film (9), wherein the integrated electronics (2) on the carrier film (9) comprise an ICC chip (8) and sensors (5, 6, 7) for detecting the temperature and the state of charge and the pressure, **characterized in that** said integrated electronics additionally comprise a transmitting/receiving unit (3) for wirelessly exchanging data with a battery control unit arranged outside of the energy storage cell (1), and also a reference electrode (10) for separately measuring an anode and cathode potential of the energy storage cell (1).

2. Monitoring system according to claim 1, **characterized in that** the integrated electronics (2) are connected to the battery control unit via an optical transmission path, in particular via an infrared transmission path with and without an electrically insulating fibre optic cable.

3. Monitoring system according to one of claims 1 to 2, **characterized in that** the integrated electronics (2) comprise sensors (5, 6, 7) or are connected to sensors (5, 6, 7), arranged in the energy storage cell (1), for detecting the temperature and/or the state of charge.

4. Monitoring system according to one of claims 1 to 3, **characterized in that** the integrated electronics (2) comprise a switchable discharge resistor (13).

5. Monitoring system according to one of claims 1 to 4, **characterized in that** the integrated electronics (2) comprise an identification code which is stored in a memory of the integrated electronics (2).

6. Monitoring system according to one of claims 1 to 5, **characterized in that** the integrated electronics (2) are configured to store data relating to usage of the cell.

7. Battery system comprising a plurality of energy storage cells (1) and a central battery control unit for controlling and monitoring the energy storage cells (1), **characterized in that** the battery system has a monitoring system according to one of claims 1 to 6.

## Revendications

1. Système de surveillance destiné à surveiller l'état d'une cellule d'accumulation d'énergie (1) servant à stocker de l'énergie électrique, en particulier d'une cellule d'accumulation d'énergie (1) galvanique ou d'une cellule d'accumulation d'énergie (1) présentant au moins un condensateur, dans lequel une électronique (2) intégrée directement dans la cellule d'accumulation d'énergie (1) sur un film de support (9) est disposée à l'intérieur de la cellule d'accumulation d'énergie (1) afin de surveiller l'état de la cellule d'accumulation d'énergie (1), dans lequel l'électronique (2) intégrée sur le film de support (9) présente une puce électronique (8), des capteurs (5, 6, 7) servant à capter la température et l'état de charge et la pression, **caractérisé en ce qu'**il présente en outre une unité d'émission/de réception (3) servant à échanger des données sans fil avec une commande de batterie disposée à l'extérieur de la cellule d'accumulation d'énergie (1), ainsi qu'une électrode de référence (10) servant à mesurer de façon séparée un potentiel d'anode et de cathode de la cellule d'accumulation d'énergie (1).

2. Système de surveillance selon la revendication 1, **caractérisé en ce que** l'électronique (2) intégrée est reliée à la commande de batterie avec et sans câble à fibres optiques électriquement isolant par l'intermédiaire d'une liaison de transmission optique, en particulier par l'intermédiaire d'une liaison de transmission infrarouge.

3. Système de surveillance selon l'une quelconque des revendications 1 à 2, **caractérisé en ce que** l'électronique (2) intégrée présente des capteurs (5, 6, 7) ou est reliée à des capteurs (5, 6, 7) disposés dans la cellule d'accumulation d'énergie (1), afin de capter la température et/ou l'état de charge.

4. Système de surveillance selon l'une quelconque des revendications 1 à 3, **caractérisé en ce que** l'électronique (2) intégrée présente une résistance de décharge (13) pouvant être activée.

5. Système de surveillance selon l'une quelconque des revendications 1 à 4, **caractérisé en ce que** l'électronique (2) intégrée présente un code d'identification qui est mis en mémoire dans une mémoire de l'électronique (2) intégrée.

6. Système de surveillance selon l'une quelconque des revendications 1 à 5, **caractérisé en ce que** l'électronique (2) intégrée est conçue pour mettre en mémoire des données concernant l'utilisation des cellules.

7. Système de batterie comprenant plusieurs cellules d'accumulation d'énergie (1) et une commande de batterie centrale pour la commande et la surveillance des cellules d'accumulation d'énergie (1), le système de batterie étant **caractérisé en ce qu'**il présente un système de surveillance selon l'une quelconque des revendications 1 à 6.
